# EUROPEAN PATENT SPECIFICATION

(11) **EP 2 057 006 B1**
(45) Date of publication and mention of the grant of the patent: **12.02.2014**
(21) Application number: 06844998.2
(22) Date of filing: 08.12.2006
(51) Int. Cl.: H05K 3/32, B32B 27/00, H01B 1/22, H01B 1/24, H01R 13/24

(54) **METHOD FOR FABRICATING AN ELECTRONIC DEVICE**
VERFAHREN ZUR HERSTELLUNG EINER ELEKTRONISCHEN VORRICHTUNG
PROCÉDÉ DE FABRICATION D'UN DISPOSITIF ÉLECTRONIQUE

(30) Priority: 03.05.2006 US 418414
(43) Date of publication of application: 13.05.2009
(60) Divisional application: 13171999.9
(73) Proprietor: Trillion Science, Inc., Fremont, CA 94555 (US)
(72) Inventor: LIANG, Rong-chang, Cupertino, CA 95014 (US); HO, Shih-wei, Cupertino, CA 95014 (US); LIU, Eric, H., Cupertino, CA 95014 (US); XU, Qianfei, Mountain View, CA 94040 (US)
(74) Representative: Richards, John
(86) International application number: PCT/US2006/046807
(87) International publication number: WO 2007/130137

(56) References cited:
- EP-B1- 1 168 373
- US-A- 4 740 657
- US-A- 5 087 494
- US-A- 5 162 087
- US-A- 5 613 862
- US-A- 5 839 188
- US-A- 5 851 644
- US-A- 6 011 307
- US-A1- 2001 008 169
- US-B1- 6 214 460
- US-B1- 6 352 775
- US-B2- 6 884 833
- GENGEL G.: 'Process for the Manufacture of Cost Competitive MCM Substrates.' MCM '94 PROCEEDINGS 1994, pages 182 - 187, XP008107917

## Description

### BACKGROUND OF THE INVENTION

### 1. Field of the Invention

This invention relates generally to the manufacturing methods of an electronic device, in particular an anisotropic conductive film (ACF). More particularly, this invention relates to new manufacturing processes of an ACF of improved resolution and reliability of electrical connection at a significantly lower production cost.

### 2. Description of the Related Art

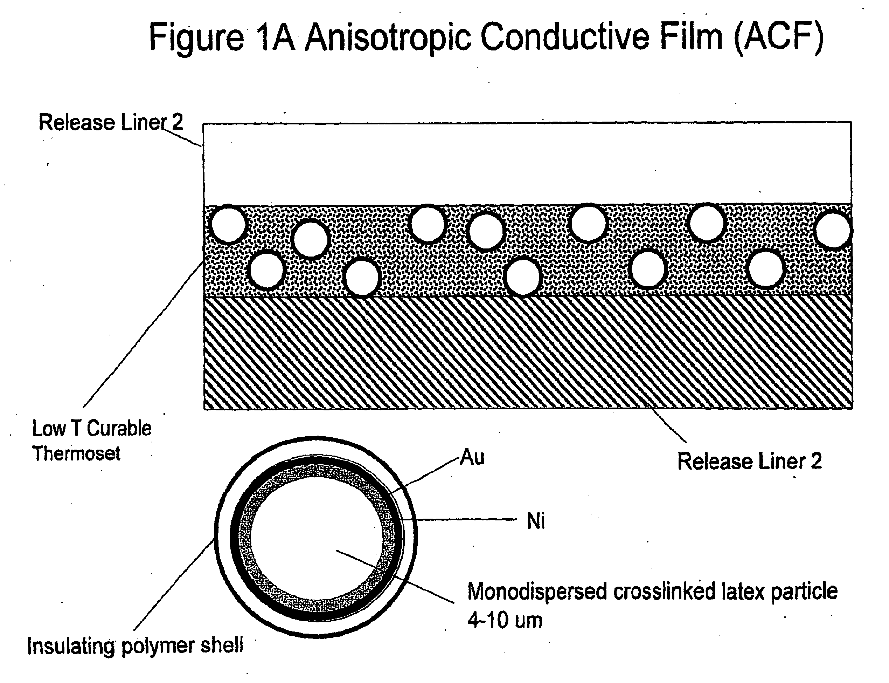

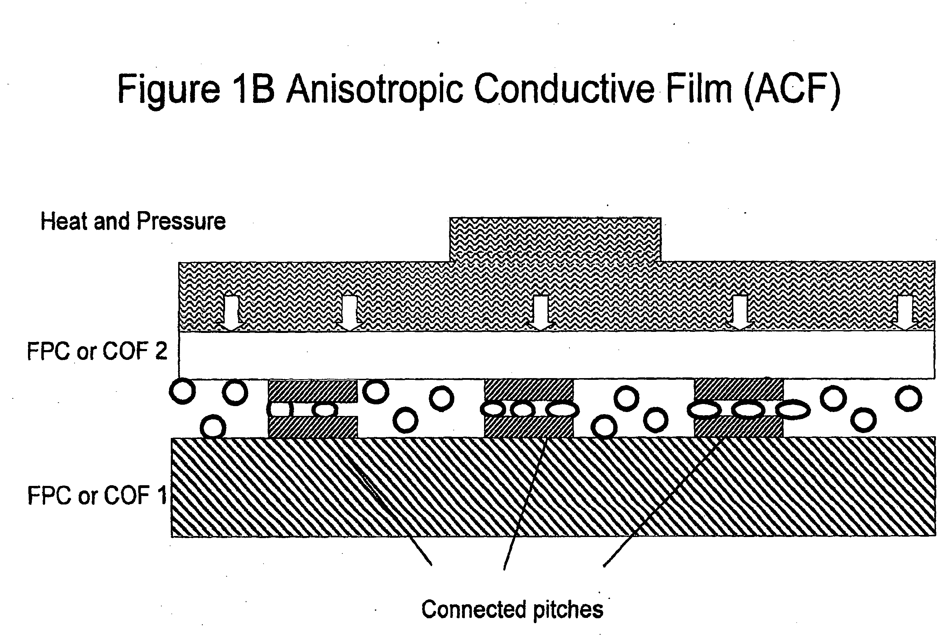

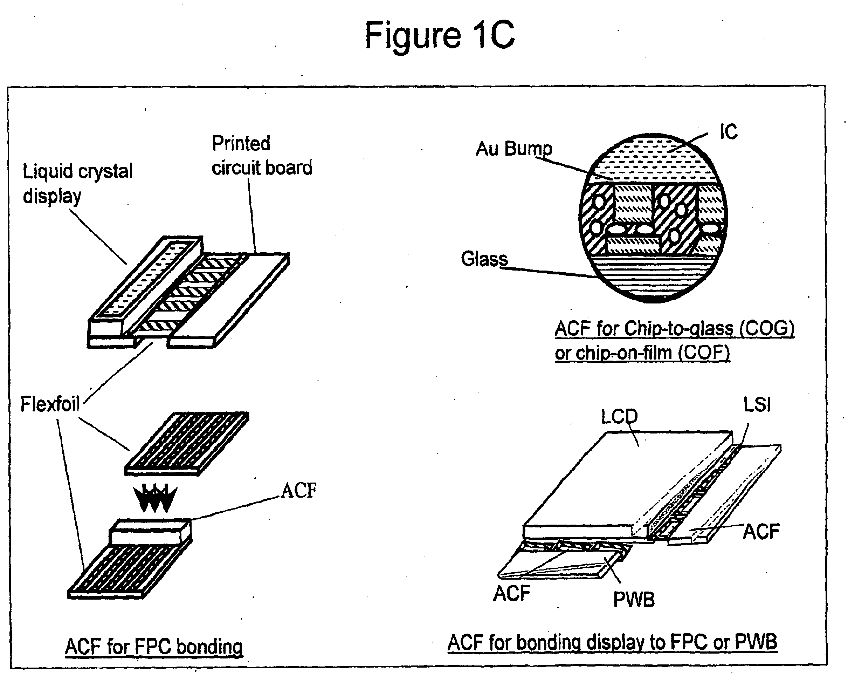

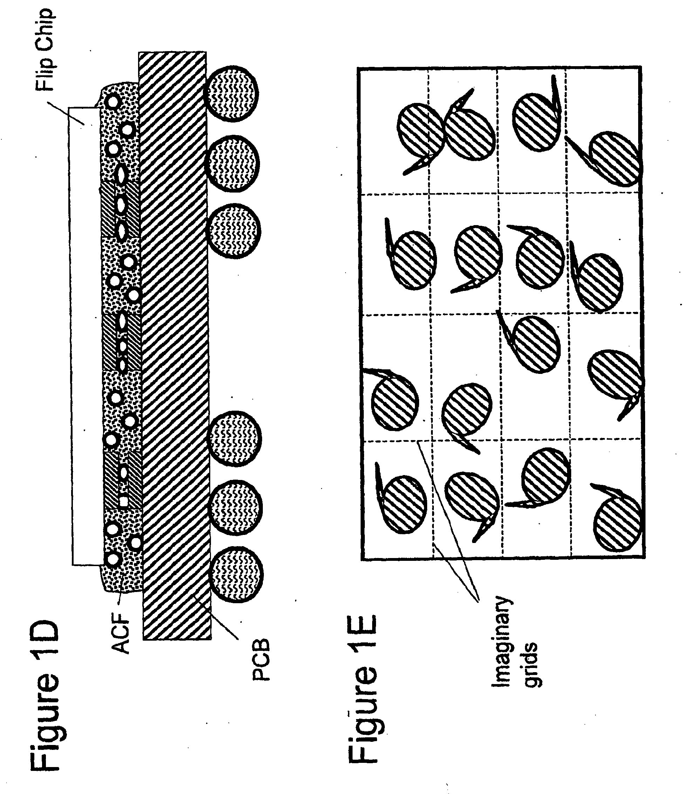

Current technologies for manufacturing anisotropic conductive films (ACF) or Z-axis conductive adhesive film (ZAF) for interconnecting array of electrodes such as those in liquid crystal display interconnections, chip-on-glass, chip-on-film, flip chip bonding and flexible circuits applications, are still challenged by several major technical difficulties and limitations. For those of ordinary skills in the art, there are still no technical solutions to overcome these difficulties and limitations. The ACF or ZAF comprising conductive particles dispersed in the adhesive film allows electric interconnection in the Z-direction through the thickness of the ACF layer. But horizontally these conductive particles are spaced far enough apart so that the film is electrically insulating in the X-Y directions. ACF comprising electrically conductive particles formed of narrowly dispersed metal-coated plastic particles such as Au/Ni-plated crosslinked polymer beads were taught in for examples, US Patents 4,740,657, 6,042,894, 6,352,775, 6,632,532 and J. Applied Polymer Science, 56, 769 (1995). Figure 1A shows a typical ACF comprising two release films, an adhesive and conductive particles dispersed therein. Fig. 1B shows an exemplary application of an ACF implemented for providing vertical electrical connections between a top and bottom flexible printed circuit (FPC) or chip on film (COF) packages. Figure 1C and 1D show the schematic drawings of some typical ACF applications in connecting electrodes and IC chips. To ensure good electric contacts between the electrodes disposed above and below the ACF, conductive particles formed with rigid metallic spikes extended out from the particle surface may be implemented. These rigid metallic spikes improve the reliability of electric connection between electrodes susceptible to corrosion by penetrating through the corrosive film that may be developed over time on the surface of the electrodes.

The first difficulty faced by the conventional technologies is related to the slow and costly processes commonly employed in the preparation and purification of the narrowly dispersed conductive particles commonly implemented as the anisotropic conductive medium. The second difficulty is related to the preparation of ACF for high resolution or fine pitch application. As the pitch size between the electrodes decreases, the total area available for conductive connection in the z-direction by the ACF also decreases. Increasing the concentration of the conductive particles in ACF may increase the total connecting area available for connecting electrodes along the z-direction. However, the increase in the particle concentration may also result in an increase in the conductivity in the x-y direction due to the probability of increase of undesirable particle-particle interaction or aggregation. The degree of aggregation of particles in a dry coating film in general increases dramatically with increasing particle concentration, particularly if the volume concentration of the particles exceeds 15-20%. An improved ACF was disclosed in US Patent 6,671,024 in which a predetermined number of conductive particles were uniformly sprinkled onto an adhesive layer by for examples airflow, static electricity, free falling, spraying, or printing. However, the concentration of the conductive particles that may be used in the processes is still limited by the statistic probability of particle-particle contact or aggregation.

Attempts to reduce the conductivity in the X-Y plane have been disclosed in prior art such as US Patent 5,087,494 (1992), in which a process of making conductive adhesive tape was disclosed by making a predetermined pattern of dimples of a low adhesive surface followed by filling each dimple with a plurality of electrically conductive particles optionally with a binder. An adhesive layer was then applied as an overcoat onto the filled dimples.

In US Patent 5,275,856 (1994), a similar fixed array ACF having an array of perforation was disclosed. Each perforation contains a plurality of electrically conductive particles in contact with an adhesive layer, which is substantially free from electrically conductive material. In either case, the dimple or perforation was filled with, for example, a conductive paste or ink comprising dispersed conductive particles such as silver and nickel particles, and each dimple or perforation contains a plurality of conductive particles. The resultant filled dimples or perforation is relatively rigid and not easy to deform during bonding. Moreover, the filling process often results in an under-filled dimple or perforation due to the presence of solvent or diluent in the paste or ink. A high electrical resistance in the bonding area and a poor environmental and physicomechanical stability of the electric connections are often the issues of this type of ACFs.

In US Patents 5,366,140 and 5,486,427, another type of fixed array ACF was disclosed. A thin, low melting metal film on a carrier substrate was cut through the metal layer into a predetermined grid pattern and heated to a temperature higher than the melting point of the metal layer. The metal is beaded up due to the high surface tension of the metal and form an array of metal particles on the substrate. The process relies on a sophisticated balance of surface tension of the metal and the adhesion at the metal/substrate interface. The metal beading process is very susceptible to the presence of impurity or contamination on the surface/interface. The size of the metal bead may be formed by this process is also relatively limited. The shape of the metal bead is also mainly semispherical. A spike on the bead surface is quite difficult to form. Moreover, the metal bead is not easy to deform during bonding and results in a high electrical resistance in the bonding area more often with a poor environmental and physicomechanical stability of the electric connections.

In US Patent 4,606,962, a process of forming ordered array of conductive particles was disclosed. Said process includes the steps of rendering areas of an adhesive coating substantially tack-free followed by applying electrically conductive particles only onto the tacky area of the adhesive. In 5,300,340 (1994) an ACF was prepared by printing an array of conductive particles on a carrier web by for example a negative-working Toray waterless printing plate. In US 5,163,837 an ordered array of connector was prepared by depositing an adhesive into the mesh of an insulating mesh sheet followed by applying discrete electric contacts of a size to fit and fill the mesh. In either the direct or direct printing of conductive particles on a substrate, the size of the printed dots tends to be relatively big and non-uniform and missing particles or aggregation of particles are problems for reliable connections. The resultant ACF is not suitable for fine pitch applications.

US Patent 5,522,962 (1996) taught a method of forming ACF by (1) coating electrically conductive ferromagnetic particles into recesses such as grooves of a carrier web (2) providing a binder, and (3) applying a magnetic field sufficient to align the ferromagnetic particles into continuous magnetic columns, said magnetic columns extending from a recess in said carrier web. The process may allow a better separation of conductive materials by aligning the particles into well separate columns. However, the mechanical integrity, conductivity, and compressibility of metallic columns are still potential problems for reliable connections.

A fixed array ACF was disclosed by K. Ishibashi and J. Kimbura in AMP J. of Tech., Vol. 5, p.24, 1996. The manufacturing of ACF involves an expensive and tedious process including the steps of photolithographic exposure of resist on a metal substrate, development of photoresist, electroforming, stripping of resist, and finally overcoating of an adhesive. ACF produced piece-by-piece using this batch-wise process could be fine pitch. However, the resultant high cost ACF is not very suitable for practical applications partly because the compressibility or the ability to form conformation contacts with the electrodes and corrosion resistance of the electroformed metallic (Ni) columns are not acceptable and result in a poor electrical contact with the device to be connected to. A similar resin sheet comprising a fixed array of through holes filled with metal substance such as cupper with Ni/Au surface plating on the top surface was taught in US 5,136,359 and 5,438,223 and was disclosed as a testing tool by Yamaguchi and Asai in Nitto Giho, Vol. 40, p.17 (2002). The inability to form conformation contacts with electrodes remains to be an issue. It results in high electrical resistance in the bonding area and a poor long term stability of the electrical connection. Moreover, It's very difficult to form a spike on the top of the electroformed metal columns.

In US 6,423,172, 6,402,876, 6,180,226, 5,916,641 and 5.769,998, a non-random array was prepared by coating a curable ferrofluid composition comprising a mixture of conductive particles and ferromagnetic particle under a magnetic field. The ferromagnetic particles are relatively small In size and are washed away later to reveal an array of conductive particles well separated from each other. The processes of using ferromagnetic particles and the subsequent removal of them are costly and the pitch size of the resultant ACF is also limited by the loading of the ferromagnetic particles and conductive particles. Conductive particles with a spike may be used in this prior art to improve the connection to electrodes with a thin corrosion or oxide layer, but the direction of the spike on the particles prepared by this process is randomly oriented. As a result, the effectiveness of the spikes In penetrating into the oxide surface is quite low.

U.S. Patent Publication No. 2001/0008169 (July 19,2001) disclosed an anisotropic conductive adhesive having an adhesive layer and conductive particles individually adhered to the adhesive layer, the conductive particles being arranged in an ordered array. The size of the conductive particles is at least somewhat smaller than the thickness of the adhesive layer. Also disclosed is an anisotropic conductive adhesive having an adhesive layer, conductive particles individually adhered to the adhesive layer, and a release liner having an ordered array of dimples. The conductive particles reside in a single layer in the dimples. The anisotropic conductive adhesive is made by placing the conductive particles in an ordered array of dimples on a low adhesion surface. An adhesive layer is then laminated on top such that the conductive particles individually adhere to the adhesive layer. The anisotropic conductive adhesive may be used to electrically connect fine pitch electrodes on opposing circuit layers.

A substrate manufacturing process was disclosed by Glenn Gengel in "Process for the Manufacture of Cost Competitive MCM Substrates," MCM '94 PROCEEDINGS, 1994, pages 182-187, XP008107917. The process of manufacturing is based upon roll-to-roll manufacturing techniques. The pairs are kept in roll form until layer pair lamination, avoiding unnecessary handling and damage.

Figure 1E shows the schematic drawing (not to scale) of a cross sectional view of a non-random array of conductive particles with a more or less random distribution of spike direction prepared according to the methods of US 6,423,172,6,402,876, 6,180,226, 5,916,641 and 5,769,996. The presence of the spike improves the reliability and effectiveness of connection to the electrodes, particularly to electrodes that are susceptive to corrosion or oxidation. However, only the spikes directed toward the electrode surface are effective in penetrating into the oxide layer of the electrode.

Therefore, a need exits in the art to provide an improved configuration and procedure for the manufacturing of ACF, particularly those with improved pitch resolution and connection reliability particularly for those electrodes that are susceptive to oxidation or corrosion.

### SUMMARY OF THE PRESENT INVENTION

To facilitate a detailed description of the present invention, we describe herein the numerous innovative aspects of our manufacturing technology to make ACFs implemented with non-random array or arrays of conductive particles.

The first aspect of the present invention is directed to an improved method of making non-random array ACFs by a method as defined in claim 1.

The ACFs prepared according to the present invention also provide a better resolution, reliability of electrical connection at a lower manufacturing cost.

In summary, this invention discloses new manufacturing processes of an ACF of improved resolution and reliability of electrical connection using a non-random array of microcavities of predetermined configuration, shape and dimension. The manufacturing process includes the steps of (i) fluidic self-assembly of conductive particles onto a substrate or carrier web comprising a predetermined array of microcavities.

The thus prepared filled conductive microcavity array is then over-coated or laminated with an adhesive film.

These and other objects and advantages of the present invention will no doubt become obvious to those of ordinary skill in the art after having read the following detailed description of the preferred embodiment which is illustrated in the various drawing figures.

### BRIEF DESCRIPTION OF THE DRAWINGS

Figs. 1A to 1D are the schematic drawing of cross sectional views of a typical ACF product and their uses in electrode connection or chip bonding. Figure 1E shows the cross sectional view of a conventional non-random array of conductive particles with a random distribution of spike directions.
Fig. 2A and 2B are the schematic drawings of the top view and cross section view of a non-random array ACF fabricated according to the method of the present invention (the conductive particle approach). Figures 2C, 2D, 2E and 2F are schematic drawings of other non-random array ACFs fabricated according to the method of the present invention.
Figs. 3 is the schematic flow charts showing the fluidic assembling of conductive particles into the array of micro-cavities according to the present invention.
Figs. 4 is the schematic flow charts showing the transferring of the array of fluidic assembled conductive particles to a second web preferably pre-coated with an adhesive layer.
Fig. 5A and 5B show the schematic drawing (not to scale) of the cross sectional view of another non-random array ACFs fabricated according to the method of the present invention.
Figures 6A-1, 6B-1 and 6C-1 show the schematic 3-D drawings of some typical molds for the preparation of micro-cavity arrays 6A-2, 6B-2 and 6C-2, respectively. All the molds and the corresponding micro-cavity arrays are of predetermined and substantially well-defined configuration, shape and size.
Figure 6D shows the schematic drawing (not to scale) of several micro-cavities having various shapes (semispherical, square, rectangular, hexagonal, column...etc) and substructures (spikes, nodules, notches, wedges, grooves, etc.).
Figs. 7A and 7B show the schematic drawings (not to scale) of the cross sectional view for a deformed conductive particle or filled microcavity after bonding for improved connection reliability.
Fig. 8A, 8B and 8C show the schematic drawings (not to scale) of a cross sectional view of an array of filled conductive microcavities comprising substructures such as spikes, nodular, notches, wedges, grooves, etc, all the substructure may be directed substantially downward and manufactured easily by for examples, embossing, stamping, or lithographic methods.
Fig. 9 shows the schematic drawing (not to scale) of a configuration of an ACF comprising two non-random arrays of filled conductive micro-cavities, laminating face-to-face to form a sandwich structure such as Substrate-1/non-random array micro-cavities-1/adhesive/ non-random array microcavities-2/Substrate-2.
Figure 10A is a schematic drawing of an array of micro-cavities with a spike substructure.

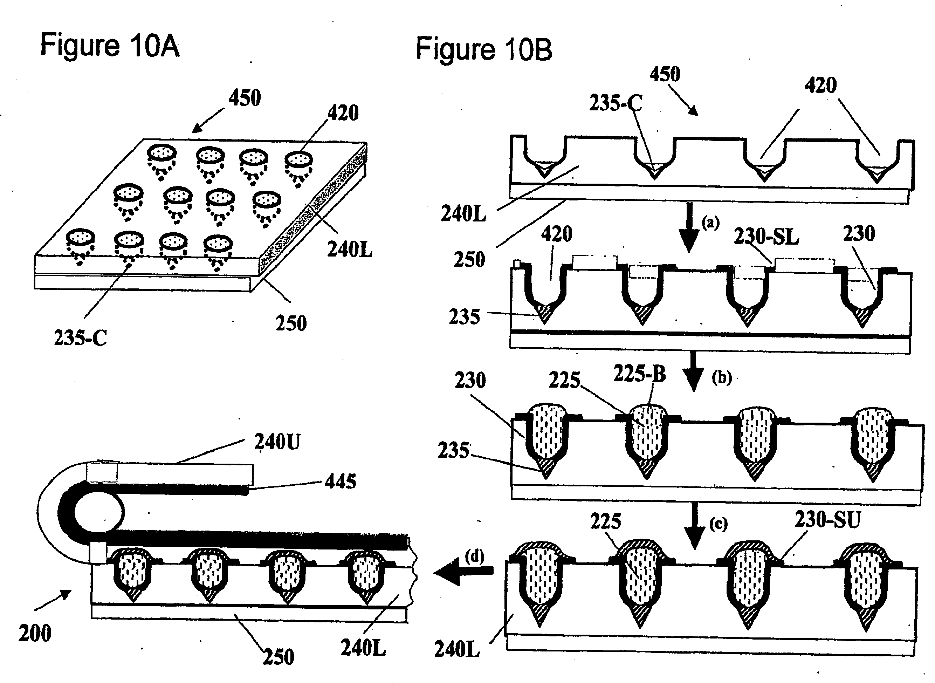

Figure 10B is the schematic flow charts showing the processing steps of the 8^{th} aspect of the present invention comprising: (a) selectively metallizing the surface of the microcavities including some top surface area of partition around the skirt of the microcavities; (b) filling the microcavities with a filler preferably polymeric filler and removing or scrapping off the excess of the filler; (c) selectively metallizing the surface of the filled microcavities preferably including some top surface area of partition around the skirt of the microcavities; and (d) overcoating or laminating the resultant array of filled conductive microcavities with an adhesive optionally with a second substrate.

### DETAILED DESCRIPTION OF THE PREFERRED EMBODIMENT

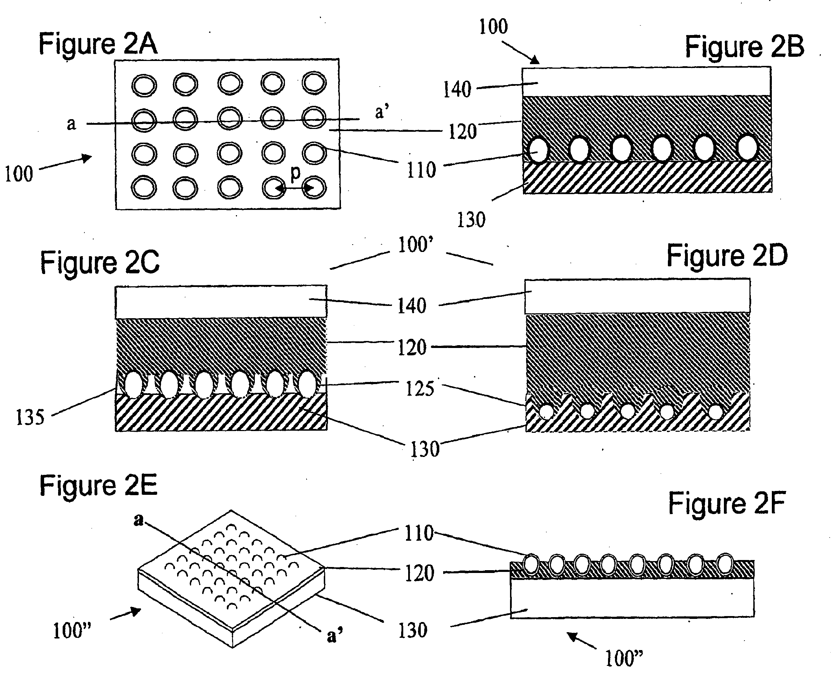

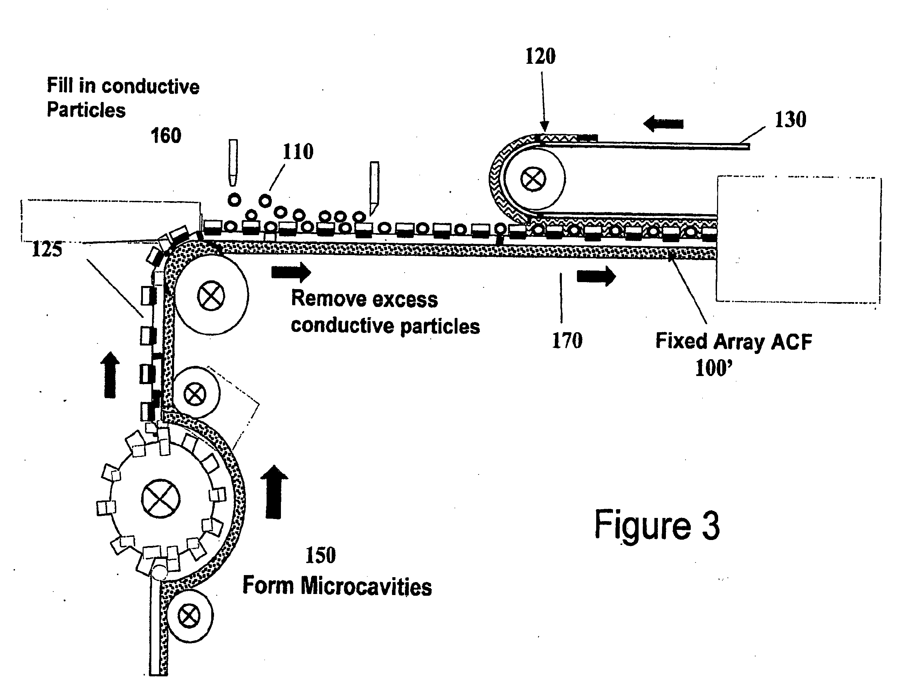

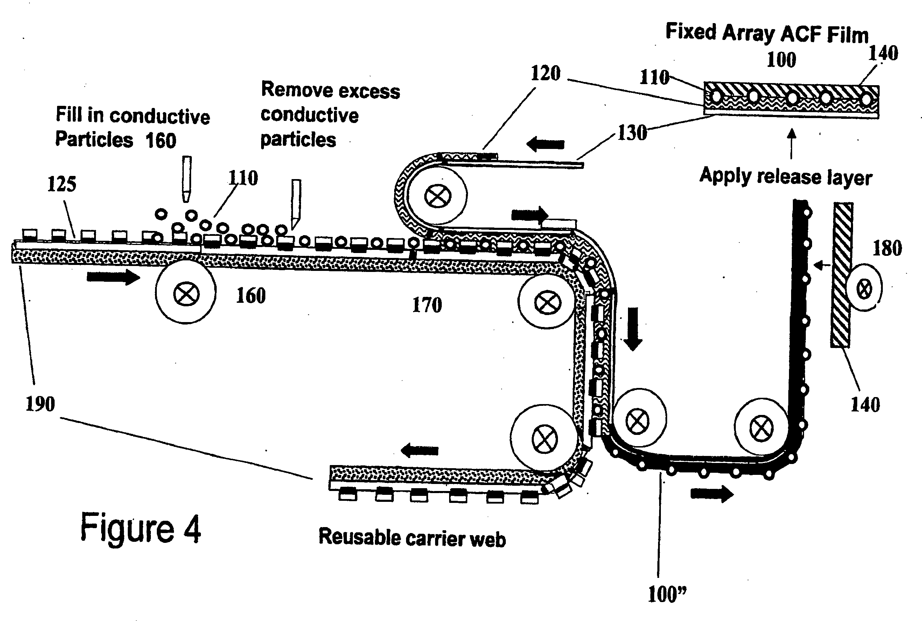

Figures 2A to 2F are a top view and side cross sectional views respectively of an ACF (100). Figure 2A shows the schematic top view of the ACF and Figure 2B shows the schematic side cross sectional view along a horizontal line a-a' of the top view. The ACF (100) includes a plurality of conductive particles (110) disposed at predetermined locations in an adhesive layer (120) between a bottom (130) and top substrates (140). Figures 2C and 2D show two schematic side cross sectional views of an ACF (100') along the horizontal line a-a' shown in Fig. 2A. The ACFs (100 and 100') include a plurality of conductive particles (110) disposed in a plurality of micro-cavities (125) formed between a bottom and top substrates 130 and 140 respectively with the space between the top and bottom substrates filled with adhesive (120). The micro-cavities (125) may be formed directly on the substrate (130) or on a separate layer (135) above the substrate (130). The depth of the micro-cavities (125) is preferably larger than the radius of the conductive particles (110), even more preferably larger than the diameter of the conductive particles. The opening of the micro-cavities is so selected that only one conductive particle (110) can be contained in each micro-cavity (125). The pitch "p" between the conductive particles can be well defined as the pitch between the micro-cavities. The processes of fabricating the non-random array or non-random ACFs (100') and (100) are shown in Figure 3 and Figure 4, respectively. The pitch "p" between the conductive particles can be predetermined and well defined according to the manufacturing processes described below.

As shown in Figure 3, the process of the present invention starts from a process of making a plurality of micro-cavities (125) by for example, laser ablation, embossing, stamping or lithographic process (not shown) at a first stage (150) of a roll-to-roll ACF production station. The microcavity array may be formed directly on the web or on a cavity-forming layer pre-coated on the carrier web. Suitable materials for the web include, but are not limited to polyesters such as poly ethylene terephthalate (PET) and polyethylene naphthalate (PEN), polycarbonate, polyamides, polyacrylates, polysulfone, polyethers, polyimides, and liquid crystalline polymers and their blends, composites, laminates or sandwich films. Suitable materials for the cavity-forming layer include, but are not limited to thermoplastic, thermoset or its precursor, positive or negative photoresist, and inorganic materials.

In a second stage160, a plurality of conductive particles, e.g., conductive particles (110), are depositing into the micro-cavities by applying a fluidic particle distribution and entrapping process wherein each conductive particle (110) is entrapped into one micro-cavity (125). In the case when small particles are used, the material flow or turbulence induced by the coating and drying processes may be significant as compared to the gravitational force of the conductive particles. An additional field such as magnetic field or electric field or both may be applied to facilitate the fluidic assembly. The particles may be applied onto the microcavity web by methods including coating such as slot coating, gravure coating, doctor blade, bar coating and curtain coating, printing such as inkjet printing, and spraying such as nozzle spraying.

The excess conductive particles (110) are then removed by for example, a wiper, doctor blade, air knife or solvent spraying at the end of the second stage (160). The particle deposition step may be repeated to assure no missing particles in the micro-cavities. In a third stage (170), the conductive particles (110) deposited in the micro-cavities are laminated to a second substrate (130) precoated with an adhesive layer (120) in the lamination station (180) as shown in Fig. 4, to form a non-random array ACF (100). Figure 2C and 2D show two schematic ACFs prepared according to the process of Figure 3 wherein particles (110) and micro-cavities (125) having various ratios of the particle diameter to the depth of the micro-cavity may be used. Alternatively, an adhesive may be coated directly onto the filled micro-cavities, optionally followed by a lamination onto the second substrate (130).

Figure 4 shows a schematic flow of the ACF manufacturing process using a temporary carrier web (190) comprising an array of micro-cavities. The microcavity array may be formed directly on the temporary carrier web or on a cavity-forming layer pre-coated on the carrier web. Suitable materials for the carrier web include, but are not limited to polyesters such as poly ethylene terephthalate (PET) and polyethylene naphthalate (PEN), polycarbonates, polyamides, polyacrylates, polysulfones, polyethers, polyimides, polyamides, liquid crystalline polymers and their blends, composites, laminates, sandwich or metallized films. Suitable materials for the cavity-forming layer may be selected from a list comprising thermoplastics, thermosets or their precursors, positive or negative photoresists, inorganic or metallic materials.

To achieve a high yield of particle transfer, the carrier web is preferably treated with a thin layer of release material to reduce the adhesion between the microcavity carrier web (190) and the adhesive layer (120). The release layer may be applied by coating, printing, spraying, vapor deposition, thermal transfer, plasma polymerization/crosslinking either before or after the microcavity-forming step. Suitable materials for the release layer include, but are not limited to, fluoropolymers or oligomers, silicone oil, fluorosilicones, polyolefines, waxes, poly(ethyleneoxide), poly(propyleneoxide), surfactants with a long-chain hydrophobic block or branch, or their copolymers or blends.

After the fluidic filling step (160), the conductive particles in the micro-cavities may be transferred to the second substrate (130), which is preferably pre-coated with an adhesive (120) as shown in Figure 4. The temporary microcavity web (190) may then be reused by repeating the particle filling and transferring steps. Optionally, the web (190) may be cleaned by a cleaning device (not shown) to remove any residual particles or adhesive left on the web and a release coating may be reapplied before refill the particles. Still optionally, a close loop of temporary microcavity web may be used continuously and repeatedly for the particle filling, transferring, cleaning and release application steps.

The resultant film (100") may be used directly as a non-random array ACF as shown in the schematic Figures 2E (top view) and 2F (cross-section view) wherein the conductive particles (110) are on the top of the adhesive film (120) and may not be covered completely by the adhesive. Optionally, an additional thin layer of adhesive layer may be over-coated onto the as-transferred particle layer to improve the tackiness of the non-random array ACF film, particularly when the particle concentration is high. An adhesive different from that for the adhesive film (120) may be employed for the overcoating.

The film (100") may further be laminated at the lamination station (180) with a third substrate (140) which is optionally precoated with an adhesive, to result in a non-random array ACF (100) sandwiched between two substrates (130 and 140) as shown in Figure 2B. The adhesion strengths between the adhesive (120) and the two substrates (130 and 140) should be lower than the cohesion strength of the adhesive. To facilitate the sequential peeling of the two substrates from the adhesive during bonding, it is preferable that one of the adhesion strengths is substantially larger than the other.

The adhesives used in the above-mentioned processes may be thermoplastic, thermoset, or their precursors. Useful adhesives include but are limited to pressure sensitive adhesives, hot melt adhesives, heat or radiation curable adhesives. The adhesives may comprise for examples, epoxide, phenolic resin, amine-formaldehyde resin, polybenzoxazine, polyurethane, cyanate esters, acrylics, acrylates, methacrylates, vinyl polymers, rubbers such as poly (styrene-co-butadiene) and their block copolymers, polyolefins, polyesters, unsaturated polyesters, vinyl esters, polycaprolactone, polyethers, and polyamides. Epoxide, cyanate esters and multifunctional acrylates are particularly useful. Catalysts or curing agents including latent curing agents may be used to control the curing kinetics of the adhesive. Useful curing agents for epoxy resins include, but are not limited to, dicyanodiamide (DICY), adipic dihydrazide, 2-methylimidazole and its encapsulated products such as Novacure HX dispersions in liquid bisphenol A epoxy from Asahi Chemical Industry, amines such as ethylene diamine, diethylene triamine, triethylene tetraamine, BF₃ amine adduct, Amicure from Ajinomoto Co., Inc, sulfonium salts such as diaminodiphenylsulphone, p-hydroxyphenyl benzyl methyl sulphonium hexafluoroantimonate. Coupling agents including, but are not limited to, titanate, zirconate and silane coupling agents such as glycidoxypropyl trimethoxysilane and 3-aminopropyl trimethoxy-silane may also be used to improve the durability of the ACF. The effect of curing agents and coupling agents on the performance of epoxy-based ACFs can be found in S. Asai, et al, J. Appl. Polym. Sci., 56, 769 (1995). The entire paper is hereby incorporated as reference in this Patent Application.

Suitable conductive particles for the present invention are of a narrow particle size distribution with a standard deviation of less than 10%, preferably, less than 5%, even more preferably less than 3%. The particle size is preferably in the range of 1 to 250 um, more preferably 2-50 um, even more preferably 3-10 um. The size of the microcavities and the conductive particles are carefully selected so that each micro-cavity has a limited space to contain only one conductive particle. To facilitate particle filling and transferring, microcavity having a tilted wall with a wider top opening than the bottom may be employed.

Conductive particles comprising a polymeric core and a metallic shell are particularly preferred. Useful polymeric cores include but are not limited to, polystyrene, polyacrylates, polymethacrylates, polyvinyls, epoxy resins, polyurethanes, polyamides, phenolics, polydienes, polyolefins, aminoplastics such as melamine formaldehyde, urea formaldehyde, benzoguanamine formaldehyde and their oligomers, copolymers, blends or composites. If a composite material is used as the core, nano particles or nano tubes of carbon, silica, alumina, BN, TiO₂ and clay are preferred as the filler in the core. Suitable materials for the metallic shell include, but are not limited to, Au, Pt, Ag, Cu, Fe, Ni, Sn, Al, Mg and their alloys. Conductive particles having interpenetrating metal shells such as Ni/Au, Ag/Au, Ni/Ag/Au are particularly useful for optimum hardness, conductivity and corrosion resistance. Particles having rigid spikes such as Ni, carbon, graphite are useful in improving the reliability in connecting electrodes susceptible to corrosion by penetrating into the corrosive film if present.

The narrowly dispersed polymer particles useful for the present invention may be prepared by for examples, seed emulsion polymerization as taught in US patents 4,247,234, 4,877,761, 5,216,065 and Ugelstad swollen particle process as described in Adv., Colloid Interface Sci., 13, 101 (1980); J. Polym. Sci., 72, 225 (1985) and "Future Directions in Polymer Colloids", ed. El-Aasser and Fitch, p. 355 (1987), Martinus Nijhoff Publisher. In one preferred embodiment of the present invention, monodispersed polystyrene latex particle of 5 um diameter is used as the deformable elastic core. The particle is first treated in methanol under mild agitation to remove excess surfactant and to create microporous surfaces on the polystyrene latex particles. The thus treated particles are then activated in a solution comprising PdCl₂, HCl and SnCl₂ followed by washing and filtration with water to remove the Sn⁴⁺and then immersed in an electroless Ni plating solution (from for example, Surface Technology Inc, Trenton, NJ) comprising a Ni complex and hydrophosphite at 90°C for about 30-50 minutes. The thickness of the Ni plating is controlled by the plating solution concentration and the plating conditions (temperature and time).

The Ni coated latex particle is then placed in an immersion Au plating solution (for example from Enthone Inc.) comprising hydrogen tetrachloroaurate and ethanol at 90°C for about 10 to 30 minutes to form interpenetrating Au/Ni shells having a total metal (Ni + Au) thickness of about 1 um. The Au/Ni plated latex particles are washed with water and ready for the fluidic filling process. Processes for coating conductive shell on particles by electroless and/or electroplating were taught in for examples, US 6,906,427 (2005), US 6,770,369 (2004), US 5,882,802 (1999), US 4,740,657 (1988), US Patent Application 20060054867, and Chem. Mater.,11, 2389-2399 (1999).

Fluidic assembly of IC chips or solder balls into recess areas or holes of a substrate or web of a display material has been disclosed in for examples, US patents 6,274,508, 6,281,038, 6,555,408, 6,566,744 and 6,683,663. Filling and top-sealing of electrophoretic or liquid crystal fluids into the microcups of an embossed web were disclosed in for examples, US patents 6,672,921, 6,751,008, 6,784,953, 6,788,452, and 6,833,943. Preparation of abrasive articles having precise spacing by filling into the recesses of an embossed carrier web an abrasive composite slurry comprising a plurality of abrasive particles dispersed in a hardenable binder precursor was also disclosed in for examples, US patents 5,437,754, 5,820,450 and 5,219,462. All of them are hereby incorporated as references. In all the above-mentioned prior art, recesses, holes or microcups were formed on a substrate by for example, embossing, stamping or lithographic processes. A variety of materials were then filling into the recesses or holes for various applications including active matrix thin film transistors (AM TFT), ball grid arrays (BGA), electrophoretic and liquid crystal displays. However, none of the prior art disclosed the preparation of ACFs by fluidic filling of only one conductive particle in each micro-cavity or recess. Also, none of the prior art taught the fluidic self assembly of conductive particles comprising a polymeric core and a metallic shell.

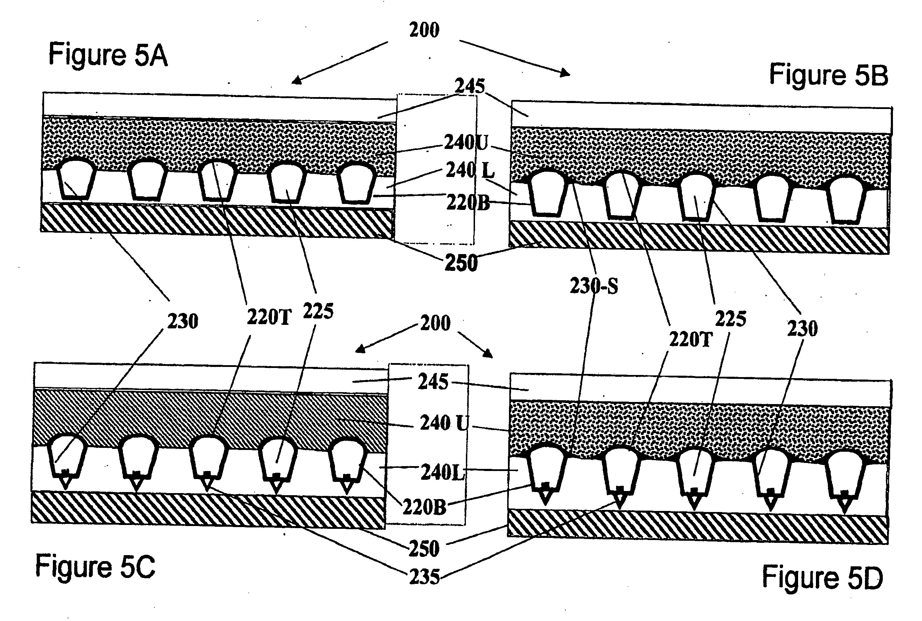

Referring to Figs. 5A to 5D for several ACF configurations. Instead of conductive particles as that commonly implemented in the conventional ACF and as that shown in Figures 2A-2F, the ACF (200) provides the z-direction electric conductivity by a plurality of micro-cavities (220) filled with a polymeric core (225) and surrounded by a metallic shell (230). As shown in Fig. 5A, the micro-cavities are disposed in adhesive layers (240U and 240L) supported between a top (245) and a bottom (250) substrate. The two adhesive layers (240U and 240L) may be of the same composition. The micro-cavities may be formed by for example, laser ablation, stamping, embossing or lithography and the metallic shell (230) is deposited thereon. When an embossing process is employed, tilted walls are preferable to vertical walls for more convenient mold release. In Fig. 5B, the metallic shell (230) has a skirt edge (230-S) covering the top and extending out from the top edge of the sidewalls of the metallic shell. In Fig. 5C and Fig. 5D, the micro-cavities further include a bottom spike 235 extending from a bottom surface of the metallic shell. In Fig. 5D, the micro-cavities are covered with a metallic shell having a skirt edge extension on the top surface and metallic spikes extended from the bottom surface.

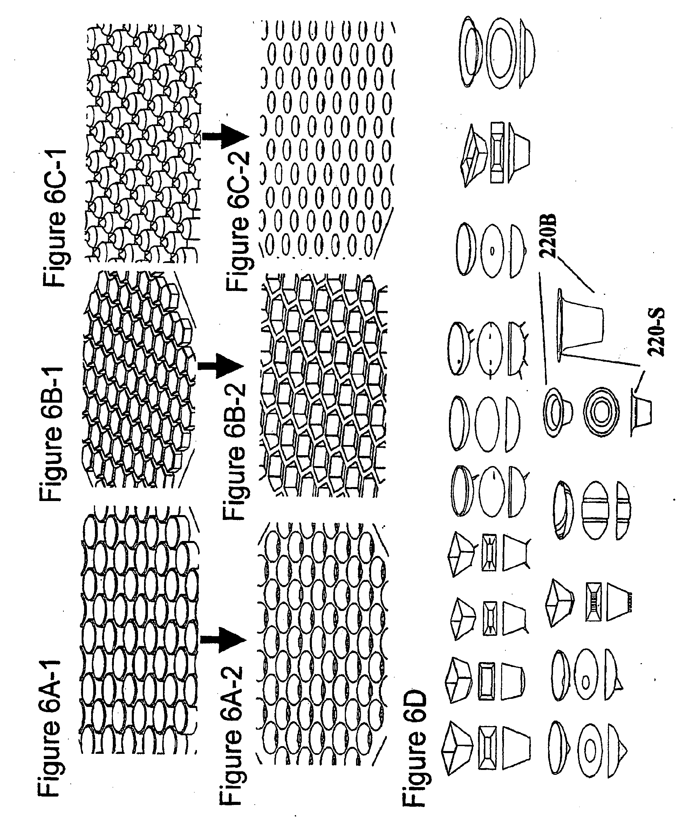

Figs. 6A to 6D are some examples of molds and micro-cavity arrays of different shapes and dimensions arranged in different kinds of configurations. The micro-cavities may be formed directly on a plastic web substrate with or without an additional cavity-forming layer. Alternatively, the micro-cavities may also be formed without an embossing mold by for example, laser ablation or a lithographic process using a photoresist followed by development and optionally an etching or electroforming step. Suitable materials for the cavity forming layer may be selected from a list comprising thermoplastic, thermoset or its precursor, positive or negative photoresist, inorganic or metallic materials.

Figs. 6A-1, 6B-1 and 6C-1 are the 3D schematic drawings of three different embossing molds and Figs. 6A-2, 6B-2 and 6C-2 are the corresponding three arrays of micro-cavities respectively, formed by applying the molds.

Fig. 6D shows a variety of examples of micro-cavities having different configurations and different types of metallic spikes extended from the bottom surface of the micro-cavities. The skirt edge extension (230-S) improves the electric connection between the top metallic shell (220T) and the bottom metallic shell (220B). To further assure the electric connection, the micro-cavities may also be formed with a curved edge (220-S).

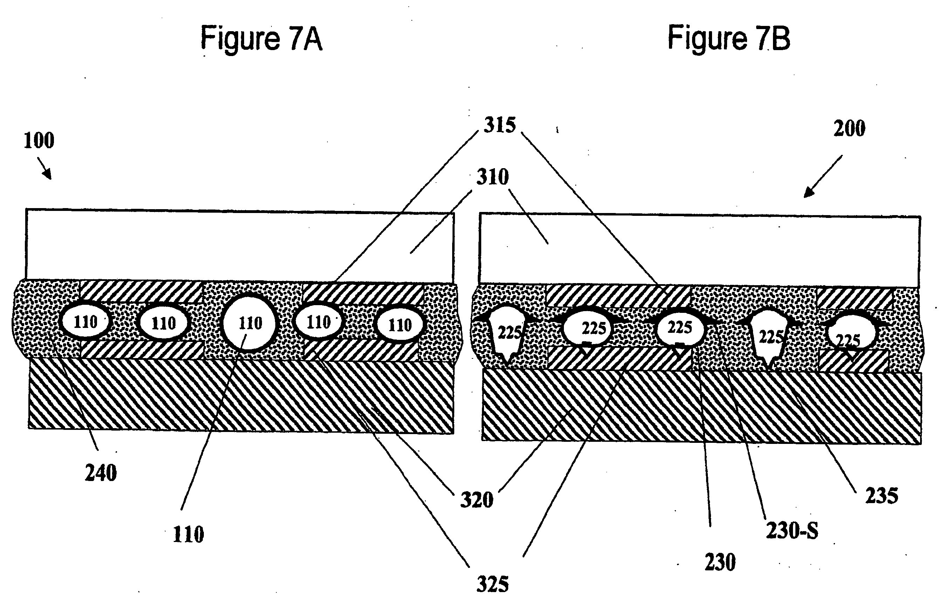

Figs. 7A and 7B shows the actual application of the ACFs 100 and 200 respectively for providing electrically connections between a top (315) and bottom (325) electrodes attached to a top (310) and bottom (320) flexible printed circuit board (FPC) or chip-on-film (COF), respectively. In Fig. 7A, the conductive particles 110 with deformable elastic core are squeezed into an elliptic shape by the electrodes 315 and 325 and a vertical electric connection is established. In Fig. 7B, the micro-cavities (220, not marked) filled with a deformable core (225) surrounded by the metallic shell (230) optionally with a skirt (230-S) and bottom spikes (235) are pressed on by the top (315) and bottom electrodes (325). The skirt top shell (230-S) provides broader contact areas and the spike (235) can penetrate through a corrosive insulation layer that may develop on the surface of the electrodes 325 those assure better electric contact.

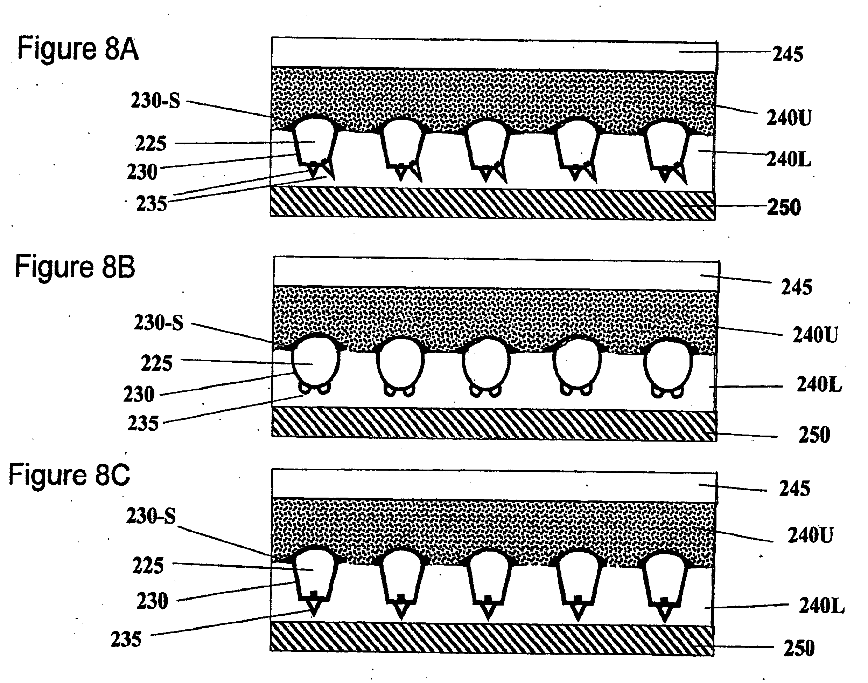

Figures. 8A to 8C show different shapes of spikes (235) extended from the bottom surface of the metallic shell (230) of the micro-cavities (220, not marked). These spikes (235) may be formed as sharpened spikes, nodular, notches, wedges, grooves, etc. It is preferable that each of the metallic shell has a skirt shaped top cover (230-S) with an optimum skirt area for providing broader contact areas to enhance electric connections. Too big a skirt area may result in a decrease in the number of conductive, filled microcavities per unit area and an increase in the connection pitch size.

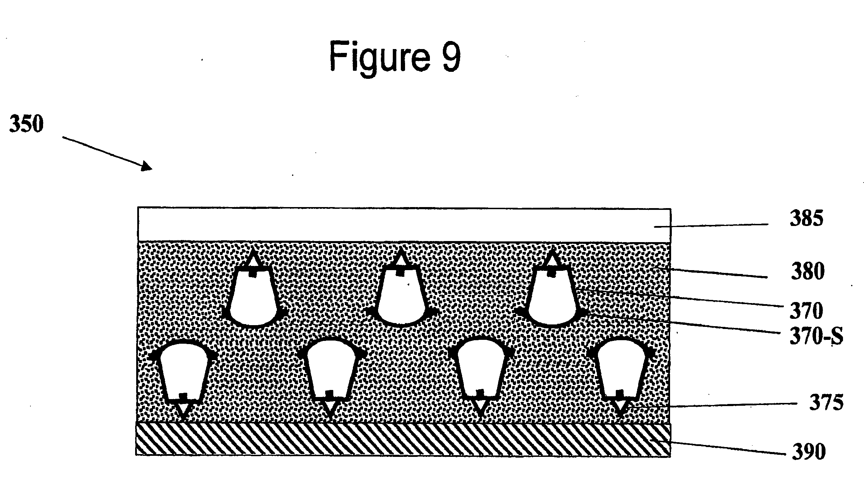

Figure 9 shows the cross sectional view of an ACF (350) which includes two non-random arrays of micro-cavities (360, not marked). Each of the micro-cavities has a metallic shell (370) and filled with deformable polymeric material. The metallic shell (370) has an optional skirt shaped cover (370-S) and spikes (375) extended from the bottom surface of the metal shell (370). The micro-cavities are disposed in an adhesive layer (380) sandwiched between a top (385) and bottom (390) substrates, respectively.

The micro-cavities as that formed in Figures 3 and 4 above may be selectively metallized in designated area by methods including, but not limited to, those listed blow:
(1) metallization through a shadow mask;
(2) coating a plating resist, photolithographic exposing, developing the resist and electroplating, particularly electroless plating the areas without the resist thereon;and
(3) image-wise printing a plating resist, release, masking or plating inhibiting (poison) layer, non-imagewise metallizing the whole surface, followed by stripping or peeling off the metal on the unwanted areas.

Image-wise printing processes useful for the present invention include, but are not limited to, inkjet, gravure, letter press, offset, waterless offset or lithographic, thermal transfer, laser ablative transfer printing processes.

Metallization processes useful for the present invention include, but are not limited to, vapor deposition, sputtering, electrodeposition, electroplating, electroless plating and replacement or immersion plating. Deposition of Ni/Au may be achieved by first activating the array surface with palladium followed by electroless Ni plating using an electroless Ni plating solution (from for example, Surface Technology Inc, Trenton, NJ) and an immersion Au plating solution (for example from Enthone Inc.) to form interpenetrating Au/Ni layers. An Ag layer may also be electroless plated using for example, a cyanide free Ag plating solution (for example from Electrochemical Products Inc., New Berlin, WI) to form an interpenetrating Ni, Ag and Au layers.

Figure 10A shows an array (450) of micro-cavities (420) each with a spike cavity (235) extended from the bottom surface of the micro-cavities (220). The micro-cavity may comprise more than one spike with different orientations. The number, size, shape and orientation of the spikes in each micro-cavity are predetermined but may be varied from cavity to cavity. The microcavities with spike substructures may be manufactured by photolithography or microembossing using a shim or mold prepared by for example, direct diamond turning, laser engraving, or photolithography followed by electroforming.

Figure 10B illustrates an ACF (200) fabrication process comprising the steps of:
(a) As shown in Fig. 10-B-2, selectively metallizating the micro-cavity array (450) comprising a substrate (250), an adhesive (240L) and microcavities (420) optionally with spike cavities (235-C) by one of the methods discussed previously with the metallic layer coated over the sidewall surfaces (230) including the surface of the spike cavities (235-C) and preferably the top surface of the skirt areas (230-S) of the micro-cavities (420) ;
(b) As shown in Fig. 1-B-3, filling an elastic deformable core material (225) into the metalized micro-cavities with the excess filling material removed outside of the micro-cavities (420).
(c) As shown in Fig. 10B-4, selectively metallizing the top (225-B) of the filling material (225) preferably with the a skirt edge of top-covering conductive metal layer also extending from the top surface of the deformable filling material (225) to the top surface areas surrounding the micro-cavities (220); and finally
(d) As shown in Fig. 10B-5, laminating the thus formed structure with an adhesive layer (240U) precoated on a substrate (445) to complete the fabrication of the ACF (200).

The adhesive (240U) may comprise materials including, but not limited to, epoxides, polyurethanes, polyacrylates, polymethacrylates, polyesters, polyamides, polyethers, phenolics, cellulose esters or ethers, rubbers, polyolefins, polydienes, cyanate esters, polylactones, polysulfones, polyvinyls and their monomers, oligomers, blends or composites. Among them, partially cured A-stage thermoset compositions comprising cyanate ester or epoxy resin and a latent curing agent are most preferred for their curing kinetics and adhesion properties.

To improve the rigidity of the spike (235), a rigid filler may be filled into the spike cavities (235-C) after the metallization step (a). Useful rigid fillers include, but are not limited to, silica, TiO₂, zirconium oxide, ferric oxide, aluminum oxide, carbon, graphite, Ni, and their blends, composites, alloys, nanoparticles or nanotubes. If the metallization step (a) is accomplished by electroplating, electroless plating or electrodeposition, the rigid filler may be added during the metallization process.

Useful deformable core materials (225) for the step (b) include, but are not limited to, polymeric materials such as polystyrene, polyacrylates, polymethacrylates, polyolefins, polydienes, polyurethanes, polyamides, polycarbonates, polyethers, polyesters, phenolics, aminoplastics, benzoguanamines, and their monomers, oligomers, copolymers, blends or composites. They may be filled into the micro-cavities in the form of solution, dispersions or emulsions. Inorganic or metallic fillers may be added to the core to achieve optimum physicomechanical and rheological properties. The surface tension of the core material (225) and the conductive shell of the micro-cavity and the skirt edge may be adjusted so that the core material form a bump shape (225-B) after the filling and the subsequent drying process. An expanding agent or blowing agent may be used to facilitate the formation of the bump shape core. Alternatively, the core materials may be filled in on-demand by for example, an inkjet printing process.

In the step (d), the adhesive layer (240U) may be alternatively applied directly onto the array by coating, spraying or printing. The coated array may be used as the ACF or further laminated with a release substrate to form the sandwich ACF (200).

### Examples

The following examples are given to enable those skilled in the art to understand the present invention more clearly and to practice it. They should not be construed as the limits of the present invention, but should be considered as illustrative and representative examples. For the demonstration of the particle filling and transfer, two types of commercially available conductive particles (110) were used: the Ni/Au particles from Nippon Chemical through its distributor, JCI USA, in New York, a subsidiary of Nippon Chemical Industrial Co., Ltd., White Plains, NY and the Ni particles from Inco Special Products, Wyckoff, NJ.

### Generation of Microcavity Array Pattern on Polyimide Film by Laser Ablation

Two types of microcavity arrays were produced on letter size 8.5"x11", 3-mil heat stabilized polyimide film (PI, 300 VN from Du Pont.) The targeted dimension of the microcavities was 6um (diameter) x 2.0um (partition) x 4um (depth) and 6um (diameter) x 2.7um (partition) x 4um (depth).

### Preparation of the Adhesive Layer (120)

A 30% stock dispersion of Min-U-Sil5 silica (a silica product from Western Reserve Chemical, Stow, Ohio) was prepared by dispersing 28.44 parts of Min-U-Sil5 in a solution containing 70 parts of isopropyl acetate (i-PrOAc), which also contains 0.14 parts of BYK 322 (from BYK-Chemie USA, Wallingford, Connecticut), 0.71 parts of Silquest A186 and 0.71 parts of Silquest A189 (both from GE Silicones, Friendly, West Virginia.)

A stock dispersion of Cab-O-Sil-M5 (from Cabot) was prepared by dispersing 10 parts of Cab-O-Sil-M5 in a solution containing 86.6 parts of i-PrOAc, 3 parts of HyProx UA11 (epoxy Bis-A-modified polyurethane from CVC Specialty Chemicals, Inc.), 0.2 parts of Silquest A186 and 0.2 parts of Silquest A189.

A 60% stock solution of phenoxy binder PKHH (from Phenoxy Specialties, Rock Hill, South Carolina) was prepared by dissolving 60 parts of PKHH in a solution containing 25 parts of acetone, 11.25 parts of epoxy resin RSL 1462 and 12.75 parts of epoxy resin RSL1739 (both from Hexion Specialty Chemicals, Inc., Houston, Texas.) To transfer particles from the microcavity carrier web (190), an adhesive composition (A) comprising the following ingredients was used: 11.54 parts of epoxy resin RSL1462 ;13.07 parts of epoxy resin RSL 1739; 27.65 parts of Epon resin165 (from Hexion Specialty Chemicals, Inc., Houston, Texas); 9.44 parts of HyProx UA11; 7.5 parts of Min-U-sil5, and 1.5 parts of Cab-o-sil-M5; 0.22 parts of Silquest A186, 0.22 parts of Silquest A189, 15 parts of paphen phepoxy resin PKHH; 0.3 parts of BYK322;14 parts of HXA 3932 (a latent hardener microcapsule from Asahi Kasei, Japan). A release PET film, UV 50 )from CPFilm) was corona treated and coated with a coating fluid containing 50% by weight of the adhesive composition (A) in i-PrOAc by a Myrad bar to form the adhesive layer (120) with a targeted coverage of about 15 g/m².

### Surface Treatment of the Temporary Microcavity Carrier (190)

A microcavity array containing microcavities of 6 um (diameter) x 4 um (depth) x 2 um (partition) was prepared by laser ablation on a 3 mil heat-stabilized polyimide film (PI, from Du Pont) to form the microcavity carrier (190). To enhance the particle transfer efficiency, two types of surface treatments were employed.

### Surface Treatment by Frekote

The non-random-array microcavity carrier was cleaned with isopropanol (IPA), dried at 60°C in a conventional oven for 1 min and coated with Frekote 700-NC solution (from Loctite) using a smooth rod with a target thickness of about 0.5 um. Excess material was wiped off from the rod with lint-free Kimwipe. The coated film was allowed to dry in air for 10min, and then further dried in a conventional oven at 60°C for 5min. The surface treated substrate is ready to use for particles filling step.

### Surface Treatment by NuSil fluorosilicones

| F-Silicone Medical Product | F-Silicone Nonmedical Product | Fluorine Content | Viscosity |
|---|---|---|---|
| MED400 | 3600 | Highest F | 100,000 cp |
| | | | 12,500 cp |
| MED420 | 3602 | Lowest F | 100,000 cp |
| | | | 12,500 cp |

Two fluorosilicones MED 400 and MED420 were obtained from NuSil. The same surface treatment procedure for the PI microarray web was performed, except that in the place of Frekote materials, each of the commercially available NuSil fluorosilicones fluids at a targeted thickness of about 0.2-0.3 um was used.

### Particle Filling into Micro-cavity Array

An exemplary step-by-step procedure for particle filling is as follows: The surface treated PI microcavity array web was coated with a large amount of a conductive particle dispersion using a smooth rod. More than one filling may be employed to assure no unfilled microcavities. The filled microcavity array was allowed to dry at room temperature for 1min and the excess particles were wiped off gently by for example a rubber wiper or a soft lint-free cloth soaked with acetone solvent. Microscope images of the filled microcavity array were analyzed by ImageTool 3.0 software. A filling yield of more than 99% was observed for all the microcavity arrays evaluated regardless of the type of surface treatment.

### Transferring the particles from the Mirco-cavity Carrier (190) to the Adhesive Layer (120)

Two exemplary step-by-step procedures for particle transfer are as follows: Nickel particles: Adopting the particle filling procedure described in the above example, a surface-treated polyimide microcavity sheet with a 6x2x4 um array configuration was filled with 4um Umicore Ni particles. The attained percentage of particle filling was typically >99%. An epoxy film was prepared with a 15um target thickness. The microcavity sheet and the epoxy film were affixed, face to face, on a steel plate. The steel plate was pushed through a HRL 4200 Dry-Film Roll Laminator, commercially available from Think & Tinker. The lamination pressure was set at a pressure of 6 lb/in (about 0.423g/cm²) and a lamination speed of 2.5 cm/min. Particles were transferred from PI microcavity to epoxy film with an efficiency ≥ 98%. Acceptable tackiness during prebond at 70°C and conductivity after main bond at 170°C was observed after the resultant ACF film was bonded between two electrodes using a Cherusal bonder (Model TM-101P-MKIII.)

Gold particles: Similarly, a surface-treated polyimide microcavity sheet with a 6x2x4 um array configuration was filled with monodispersed 4um Au particles. The attained percentage of particle filling was also >99%. An epoxy film was prepared using a #32 wire bar with a targeted thickness of 20um. Both were placed on a steel plate face-to-face. The microcavity sheet and the epoxy film were affixed, face to face, on a steel plate. The steel plate was pushed through a HRL 4200 Dry-Film Roll Laminator, commercially available from Think & Tinker. The lamination pressure was set at a pressure of 6 lb/in (or 0.423g/cm²) and a lamination speed of 2.5 cm/min. An excellent particle transfer efficiency (≥98%) was observed.

The resultant ACF films showed acceptable tackiness and conductivity after bonded between two electrodes by the Cherusal bonder (Model TM-101P-MKIII.)

Different kinds of embodiments can be implemented for either the above types of ACF and the electronic devices implemented with the ACFs disclosed in this invention. In a specific embodiment, the electrically conductive particle or microcavity having a diameter or depth in a range between one to one hundred micrometers. In another preferred embodiment, the electrically conductive particle or microcavity having a diameter or depth in a range between two to ten micrometers. In another preferred embodiment, the electrically conductive particle or microcavity having a diameter or depth with a standard deviation of less than 10%. In another preferred embodiment, the electrically conductive particle or microcavity having a diameter or depth with a standard deviation of less than 5%. In another preferred embodiment, the adhesive layer comprises a thermoplastic, thermoset, or their precursors. In another preferred embodiment, the adhesive layer comprises a pressure sensitive adhesives, hot melt adhesives, heat, moisture or radiation curable adhesives. In another preferred embodiment, the adhesive layer comprises an epoxide, phenolic resin, amine-formaldehyde resin, polybenzoxazine, polyurethane, cyanate esters, acrylics, acrylates, methacrylates, vinyl polymers, rubbers such as poly(styrene-co-butadiene) and their block copolymers, polyolefines, polyesters, unsaturated polyesters, vinyl esters, polycaprolactone, polyethers, or polyamides. In another preferred embodiment, the adhesive layer comprises an epoxide, phenolic, polyurethane, polybenzoxazine, cyanate ester or multifunctional acrylate. In another preferred embodiment, the adhesive layer comprises a catalyst, initiator or curing agent. In another preferred embodiment, the adhesive layer comprises a latent curing agent activatable by heat, radiation, pressure of a combination thereof. In another preferred embodiment, the adhesive layer comprises an epoxide and a curing agent selected from the list comprising dicyanodiamide (DICY), adipic dihydrazide, 2-methylimidazole and its encapsulated products such as Novacure HX dispersions in liquid bisphenol A epoxy from Asahi Chemical Industry, amines such as ethylene diamine, diethylene triamine, triethylene tetraamine, BF₃ amine adduct, Amicure from Ajinomoto Co., Inc, sulfonium salts such as diaminodiphenylsulphone, p-hydroxyphenyl benzyl methyl sulphonium hexafluoroantimonate. In another preferred embodiment, the adhesive layer comprises a multifunctional acrylate, multifunctional methacrylates, multifunctional allyls, multifunctional vinyls, or multifunctional vinyl ethers and a photoinitiator or a thermal initiator. In another preferred embodiment, the adhesive layer further comprises a coupling agent. In another preferred embodiment, the adhesive layer further comprises a coupling agent particularly titanate, zirconate or silane coupling agent such as gamma-glycidoxypropyl trimethoxysilane or 3-aminopropyl trimethoxysilane or titanium coupling agent. In another preferred embodiment, the adhesive layer further comprises an electrically insulating filler particle such as silica, TiO₂, Al₂O₃, boron nitride, silicon nitride.

The invention further discloses a manufacturing processes that include the steps of fluidic filling thermally conductive but electrically insulating particles onto a microcavity array followed by transferring the particles to an adhesive layer. The invention further discloses the use of a non-random array anisotropic thermally conductive adhesive film to connect an electronic device, particularly a semiconductor or display device. Conventionally, the anisotropic conductive film (ACF) is only related to the use of electrical conductive particles. However, in this invention, the conductive particle may be also thermally conductive to enhance thermal management. Furthermore, for particular applications, the particles may also be thermally conductive but electrically insulating particles. For different applications, the particles may also be thermally conductive and electrically conductive particles. Therefore, a method for manufacturing an ACF is disclosed wherein the method of placing a plurality of conductive particles into an array of micro-cavities comprising a step of employing a fluidic particle distribution process to entrap each of said conductive particles into a single micro-cavity. In a preferred embodiment, the method further includes a step of employing a roll-to-roll continuous process for carrying said step of placing a plurality of conductive particles into an array of micro-cavities followed by transferring said conductive particles to an adhesive layer. In another preferred embodiment, the method further includes a step of applying an embossing, laser ablation or photolithographic process before the step of placing said plurality of conductive particles into the array of micro-cavities. In another preferred embodiment, the step of applying the embossing, laser ablation or photolithographic process on a micro-cavity forming layer is before the step of placing the plurality of conductive particles into the array of micro-cavities. In another preferred embodiment, the method further includes a step of employing a microcavity array coated with a release layer. The release layer may be selected from the list comprising fluoropolymers or oligomers, silicone oil, fluorosilicones, polyolefines, waxes, poly(ethyleneoxide), poly(propyleneoxide), surfactants with a long-chain hydrophobic block or branch, or their copolymers or blends. The release layer is applied to the microcavity array by methods including, but are not limited to, coating, printing, spraying, vapor deposition, plasma polymerization or cross-linking. In another preferred embodiment, the method further includes a step of employing a close loop of microcavity array. In another preferred embodiment, the method further includes a step of employing a cleaning device to remove residual adhesive or particles from the microcavity array after the particle transfer step. In a different embodiment, the method further includes a step of applying a release layer onto the microcavity array before the particle filling step.

In a specific embodiment, the invention further discloses a method for fabricating an electric device. The method includes a step of placing a plurality of electrically conductive particles that include an electrically conductive shell and a core material into an array of micro-cavities followed by overcoating or laminating an adhesive layer onto the filled micro-cavities. The step of placing a plurality of conductive particles into an array of micro-cavities comprising a step of employing a fluidic particle distribution process to entrap each of the conductive particles into a single micro-cavity. In another preferred embodiment, the method further includes a step of depositing or coating an electrically conductive layer on selective areas of an array of micro-cavities followed by filling the coated micro-cavities with a deformable composition and forming a conductive shell around the micro-cavities. In a preferred embodiment, the top conductive layer shell is electrically connected to the conductive layer on the micro-cavities. In another preferred embodiment, the selective areas comprise the surface of microcavities. In another preferred embodiment, the selective areas further comprise a skirt area of the micro-cavities. In another preferred embodiment, the skirt area is an area on the top surface of the micro-cavity array and extended from the edge of the micro-cavity. In another preferred embodiment, the skirt area is 0.05 um to 20 um extended from the edge of the micro-cavities. In another preferred embodiment, the skirt area is 0.1 to 5 um extended from the edge of the micro-cavities. In another preferred embodiment, the conductive layer is deposited or coated by vapor deposition, sputtering, electroplating, electroless plating, electrodeposition or wet coating. In another preferred embodiment, the conductive layer is formed of a metal, metal alloy, metal oxide, carbon or graphite. In another preferred embodiment, the metal is Au, Pt, Ag, Cu, Fe, Ni, Co, Sn, Cr, Al, Pb, Mg, Zn. In another preferred embodiment, the metal oxide is indium tin oxide or indium zinc oxide. In another preferred embodiment, the electrically conductive layer is formed of carbon nano tube. In another preferred embodiment, the electrically conductive layer comprises multiple layer or interpenetrating layer of different metals. In another preferred embodiment, the deformable composition comprise a polymeric material. In another preferred embodiment, the polymeric material is selected from the list comprising polystyrene, polyacrylates, polymethacrylates, polyvinyls, epoxy resins, polyesters, polyethers, polyurethanes, polyamides, phenolics, polybenzoxazine, polydienes, polyolefins, or their copolymers or blend. In another preferred embodiment, the core material of the conductive particles comprises a polymer and a filler. In another preferred embodiment, the filler is selected from the list comprising nano particles or nano tubes of carbon, silica, Ag, Cu, Ni, TiO₂ and clay are preferred as the filler in the core. In another preferred embodiment, the filler is an electrically conductive filler. In another preferred embodiment, the step of filling an array of micro-cavities with the deformable material comprising a step of filling the array of micro-cavities with a polymeric composition followed by selectively depositing or coating an electrically conductive layer on the filled micro-cavities to form an electrically conductive shell. In another preferred embodiment, the method further includes a step of employing a roll-to-roll continuous process for carrying the step of depositing or coating an electrically conductive layer over selective areas of an array of micro-cavities followed by filling the micro-cavities with a deformable composition and forming a conductive shell around the micro-cavities. In another preferred embodiment, the step of deposition or coating an conductive layer on selective areas is accomplished by a method selected from the steps that may includes process of: a) metallization through a shadow mask; or b) coating a plating resist, photolithographic exposing, developing the resist and furthermore electroplating, particularly electroless plating the areas without the resist thereon. The method further includes a step of image-wise printing a plating resist, release, masking or plating inhibitor layer, non-imagewise metallizing the whole surface, followed by stripping or peeling off the metal on the unwanted areas. In another preferred embodiment, the deposition or coating an conductive layer on selective areas is accomplished by a method selected from the processes of a) metallization through a shadow mask, b) coating a plating resist, photolithographic exposing, developing the resist and electroplating, particularly electroless plating the areas without the resist thereon, or c) image-wise printing a plating resist, release, masking or plating inhibitor layer, non-imagewise metallizing the whole surface, followed by stripping or peeling off the metal on the unwanted areas. In another preferred embodiment the step of image-wise printing process is a process selected from the list comprising inkjet, gravure, letter press, offset, waterless offset or lithographic, thermal transfer, laser ablative transfer printing processes. In another preferred embodiment, the method further includes a step of applying a roll-to-roll continuous process for forming an array of micro-cavities by an embossing or photolithographic process before the step of depositing or coating an electrically conductive layer on selective areas. In another preferred embodiment, the embossing or photolithographic process is accomplished on a microcavity-forming layer. In another preferred embodiment, the micro-cavities further comprise a substructure within the micro-cavity. In another preferred embodiment, the sub-structure is a form of spike, notch, groove, and nodule. In another preferred embodiment, the sub-structure is filled with a rigid, electrically conductive composition before the step of depositing or coating an electrically conductive layer onto selective areas of the micro-cavity array. In another preferred embodiment, the rigid, electrically conductive composition comprises a metal or carbon or graphite particle or tube. In another preferred embodiment, the metal particle is a metal nano particle. In another preferred embodiment, the metal particle is a nickel nano particle. In another preferred embodiment, the electrically conductive particle further includes carbon nano particle or carbon nano tube.

According to above descriptions, drawings and examples, this invention further discloses a method of fabricating a non-random ACF that includes more than one set of micro-cavities either on the same or opposite side of the adhesive layer. In all cases, the micro-cavities have predetermined size and shape. In one particular embodiment, the micro-cavities on the same side of the adhesive film have substantially same height in the z-direction (the thickness direction). In another embodiment, the micro-cavities on the same side of the adhesive film have substantially same size and shape. The ACF may have more than one set of microcavities even on the same side of the adhesive as long as their height in the vertical direction is substantially the same to assure good connection in the specific applications of the ACF. The micro-cavities may be substantially on one side of the anisotropic conductive adhesive film. Furthermore, an embodiment discloses an electrically conductive material filling micro-cavities with spikes pointing toward substantially the same direction (toward one side of the adhesive film. In an alternate embodiment, this invention further includes an anisotropic conductive adhesive film that includes two arrays of filled electrically conductive micro-cavities, one on each side of the conductive adhesive. In a specific embodiment, these two arrays comprise microcavities of substantially the same size, shape and configuration. In another preferred embodiment, these two arrays include microcavities of different size, shape or configuration. In another preferred embodiment, these two arrays are aligned in a staggered way to allow no more than one filled microcavities in the z-direction (the thickness direction) of any horizontal position.

In addition to the above embodiment, this invention further discloses a method of fabricating an electronic device with electronic components connected with an ACF of this invention wherein the ACF has non-random conductive particle array arranged according to any one of the processing methods or combinations of the methods as described above. In a particular embodiment, the electronic device comprises a display device. In another embodiment, the electronic device comprises a semiconductor chip. In another embodiment, the electronic device comprises a printed circuit board with printed wire. In another preferred embodiment, the electronic device comprises a flexible printed circuit board with printed wire.

Although the present invention has been described in terms of the presently preferred embodiment, it is to be understood that such disclosure is not to be interpreted as limiting. Various alternations and modifications will no doubt become apparent to those skilled in the art after reading the above disclosure. Accordingly, the scope of the invention is defined by the appended claims.

## Claims

1. A method for fabricating an electronic device comprising:
depositing a plurality of conductive particles (110) into an array of micro-cavities (125) followed by transferring said conductive particles from said micro-cavities to an adhesive layer (120) for disposing said conductive particles in predefined locations in said adhesive layer, **characterized in that** the plurality of conductive particles are deposited into the array of micro-cavities through a fluidic
particle distribution and entrapping process.

2. The method of claim 1 wherein:
said step of depositing a plurality of conductive particles into an array of micro-cavities comprises a step of applying an electromagnetic field to entrap each of said conductive particles into a single micro-cavity followed by removing excess conductive particles with a wiper, doctor blade, air knife, or solvent spray.

3. The method of claim 1 wherein:
said step of depositing a plurality of conductive particles into an array of micro-cavities comprises entrapping substantially only one of said conductive particles into each of the micro-cavities.

4. The method of claim 1 further comprising:
employing a roll-to-roll continuous process for carrying said step of depositing a plurality of conductive particles into an array of micro-cavities followed by transferring said conductive particles to an adhesive layer.

5. The method of claim 1 further comprising:
employing a roll-to-roll continuous process for forming said array of micro-cavities by an embossing, laser ablation or photolithographic process on a micro-cavity forming layer before said step of depositing said plurality of conductive particles into said array of micro-cavities.

6. The method of claim 1 further comprising:
fabricating said electronic device as an anisotropic conductive device by arranging said conductive particles with at least a non-conductive distance away from neighboring conductive particles.

7. The method of claim 1 further comprising:
fabricating said electronic device as an anisotropic conductive film by arranging said conductive particles with at least a non-conductive distance away from neighboring conductive particles and disposing a first substrate on said adhesive layer.

## Patentansprüche

1. Verfahren zur Herstellung einer elektronischen Vorrichtung, wobei das Verfahren folgendes umfasst:
das Abscheiden einer Mehrzahl leitfähiger Partikel (119) in eine Anordnung von Mikrokavitäten (125), gefolgt vom Übertragen der genannten leitfähigen Partikel aus den genannten Mikrokavitäten auf eine Adhäsionsschicht (120) zum Abscheiden der genannten leitfähigen Partikel an vorher festgelegten Positionen in der genannten Adhäsionsschicht, **dadurch gekennzeichnet, dass** die Mehrzahl von leitfähigen Partikeln durch einen fluiden Partikelverteilungs- und Partikeleinschlussprozess in die Anordnung von Mikrokavitäten abgeschieden wird.

2. Verfahren nach Anspruch 1, wobei:
der genannte Schritt des Abscheidens einer Mehrzahl von leitfähigen Partikeln in eine Anordnung von Mikrokavitäten einen Schritt des Anlegens eines elektromagnetischen Felds zum Einschließen jedes Partikels der genannten leitfähigen Partikel in einer einzelnen Mikrokavität umfasst, gefolgt von dem Entfernen überschüssiger leitfähiger Partikel durch einen Abstreicher, eine Rakel, ein Luftmesser oder ein Lösemittelspray.

3. Verfahren nach Anspruch 1, wobei:
der genannte Schritt des Abscheidens einer Mehrzahl von leitfähigen Partikeln in eine Anordnung von Mikrokavitäten das Einschließen im Wesentlichen nur eines Partikels der genannten leitfähigen Partikel in jeder der Mikrokavitäten umfasst.

4. Verfahren nach Anspruch 1, wobei dieses ferner folgendes umfasst:
den Einsatz eines Rollendurchlaufprozesses zur Ausführung des genannten Schrittes des Abscheidens einer Mehrzahl von leitfähigen Partikeln in eine Anordnung von Mikrokavitäten, gefolgt von der Übertragung der genannten leitfähigen Partikel auf eine Adhäsionsschicht.

5. Verfahren nach Anspruch 1, wobei dieses ferner folgendes umfasst:
den Einsatz eines Rollendurchlaufprozesses zum Ausbilden der genannten Anordnung von Mikrokavitäten durch einen Präge-, Laserablations- oder photolithographischen Prozess auf einer Schicht zur Mikrokavitätenbildung vor dem genannten Schritt des Abscheidens der genannten Mehrzahl von leitfähigen Partikeln in die genannte Anordnung von Mikrokavitäten.

6. Verfahren nach Anspruch 1, wobei dieses ferner folgendes umfasst:
das Herstellen der genannten elektronischen Vorrichtung als anisotrope leitfähige Vorrichtung, indem die genannten leitfähigen Partikel in mindestens einem nicht leitfähigen Abstand von benachbarten leitfähigen Partikeln entfernt angeordnet werden.

7. Verfahren nach Anspruch 1, wobei dieses ferner folgendes umfasst:
das Herstellen der genannten elektronischen Vorrichtung als anisotrope leitfähige Vorrichtung, indem die genannten leitfähigen Partikel in mindestens einem nicht leitfähigen Abstand von benachbarten leitfähigen Partikeln entfernt angeordnet werden sowie das Anordnen eines ersten Substrats auf der genannten Adhäsionsschicht.

## Revendications

1. Procédé de fabrication d'un dispositif électronique comprenant l'étape consistant à :
déposer une pluralité de particules conductrices (110) dans un réseau de micro-cavités (125), puis à transférer lesdites particules conductrices desdites micro-cavités sur une couche adhésive (120) pour disposer lesdites particules conductrices à des emplacements prédéfinis dans ladite couche adhésive, **caractérisé en ce que** la pluralité de particules conductrices est déposée dans le réseau de micro-cavités par un processus de distribution et de piégeage de particules fluidiques.

2. Procédé selon la revendication 1, dans lequel :
ledit dépôt d'une pluralité de particules conductrices dans un réseau de micro-cavités comprend une étape consistant à appliquer un champ électromagnétique pour piéger chacune desdites particules conductrices dans une seule micro-cavité, puis à supprimer les particules conductrices en excès avec un racloir, une racle, lame d'air ou un pulvérisant de solvant.

3. Procédé selon la revendication 1, dans lequel :
ledit dépôt d'une pluralité de particules conductrices dans un réseau de micro-cavités comprend une étape consistant à piéger sensiblement seulement une desdites particules conductrices dans chacune des micro-cavités.

4. Procédé selon la revendication 1, comprenant en outre l'étape consistant à :
utiliser un procédé en continu à rouleaux couplés pour effectuer ledit dépôt d'une pluralité de particules conductrices dans un réseau de micro-cavités puis à transférer lesdites particules conductrices sur une couche adhésive.

5. Procédé selon la revendication 1, comprenant en outre l'étape consistant à :
utiliser un procédé en continu à rouleaux couplés pour former ledit réseau de micro-cavités par un processus d'embossage, d'ablation au laser ou de photolithographie sur une couche de formation de micro-cavités avant ladite étape de dépôt de ladite pluralité de particules conductrices dans ledit réseau de micro-cavités.

6. Procédé selon la revendication 1, comprenant en outre l'étape consistant à :
fabriquer ledit dispositif électronique comme un dispositif conducteur anisotrope en agençant lesdites particules conductrices à au moins une distance non-conductrice de particules conductrices voisines.

7. Procédé selon la revendication 1, comprenant en outre l'étape consistant à :
fabriquer ledit dispositif électronique comme un film conducteur anisotrope en agençant lesdites particules conductrices à au moins une distance non-conductrice de particules conductrices voisine et en disposant un premier substrat sur ladite couche adhésive.
